# FASCICULE DE BREVET EUROPEEN

(11) **EP 0 392 421 B1**
(45) Date de publication et mention de la délivrance du brevet: **25.01.1995**
(21) Numéro de dépôt: 90106752.0
(22) Date de dépôt: 09.04.1990
(51) Int. Cl.: H03K 21/10

(54) **Matrice de compteurs synchrones multiplexés pour circuit intégré**
Multiplex-Synchronzählermatrix für integrierte Schaltungen
Multiplexed synchronous counter matrix for integrated circuit

(30) Priorité: 12.04.1989 FR 8904817
(43) Date de publication de la demande: 17.10.1990
(73) Titulaire: CEGELEC, 92309 Levallois-Perret (FR)
(72) Inventeur: Chabanne, Raymond, F-91940 Ulis (FR); Mechadier, Fabrice, F-91190 Gif sur Yvette (FR); Merlin, Edmond, F-92290 Chatenay-Malabry (FR)
(74) Mandataire: Weinmiller, Jürgen

(56) Documents cités:
- EP-A- 0 180 680
- EP-A- 0 267 612
- US-A- 4 089 156
- US-A- 4 161 787
- US-A- 4 477 918
- US-A- 4 713 832
- PATENT ABSTRACTS OF JAPAN, vol. 6, no. 200 (E-135)[1078], 9 octobre 1982;& JP-A-57 107 641 (FUJITSU K.K.) 05-07-1982

## Description

L'invention concerne les matrices de compteurs binaires, synchrones, multiplexés qui sont destinées à être incluses dans des circuits intégrés, suivant les besoins, et qui sont donc paramétrées sen fonction de ces derniers.

De manière générale et connue pour les autres sous-ensembles fonctionnels des circuits intégrés, on s'efforce de réduire de plus possible les surfaces nécessaires à la réalisation des matrices de compteurs et le nombre de connexions nécessaires à leur fonctionnement dans un circuit intégré.

Une solution classique pour obtenir une matrice de compteurs binaires synchrones multiplexés, destinée à être composée de "n" compteurs binaires à "m" bits, consiste à définir un compteur de "m" bits que l'on reproduit "n" fois, chacun des compteurs "n" obtenus étant raccordé aux autres par une logique de multiplexage.

Or un compteur binaire à "m" bits est généralement un circuit relativement complexe dans lequel les "i-1" bits précédant un bit "i" interviennent dans le calcul de ce bit "i" et impliquent donc une structure conçue à cet effet.

De plus, chaque compteur binaire à "m" bits nécessite généralement "2m" éléments de mémoire, soit 2n.m éléments de mémoire pour la réalisation de la matrice évoquée ci-dessus. En effet les compteurs binaires classiques mettent en oeuvre des bascules, de type flip-flop, commandées par l'un ou l'autre des fronts montants ou descendants d'un signal impulsionnel d'horloge, de type binaire.

Chaque bascule est composée de deux éléments en cascade le premier mémorisant une donnée d'entrée lorsque le signal d'horloge est dans l'un de ces états, le second élément recopiant cette donnée pendant l'état suivant.

L'invention propose donc une matrice de compteurs synchrones multiplexés pour circuit intégré, qui, paramétrée à la demande, permette, par la régularité et la simplicité de sa structure, un gain sensible par rapport aux matrices connues.

Selon l'invention, ce but est atteint par la matrice de compteurs telle que définie dans la revendication 1. En ce qui concerne des exemples préférés de mise en oeuvre, référence est faite aux revendications dépendantes.

L'invention sera décrite ci-après plus en détail à l'aide d'un exemple préféré de réalisation et des figures.

La figure 1 présente un exemple de cellule de compteurs selon l'invention.

La figure 2 présente l'organisation d'une matrice de compteurs selon l'invention.

La matrice de compteurs binaires, synchrones, multiplexés selon l'invention qui est destinée à être incluse dans un circuit intégré est conçue pour comporter un nombre "n", paramétrable à la demande, de compteurs binaires, synchrones, multiplexés de m bits chacun, m étant également un nombre paramétrable à la demande.

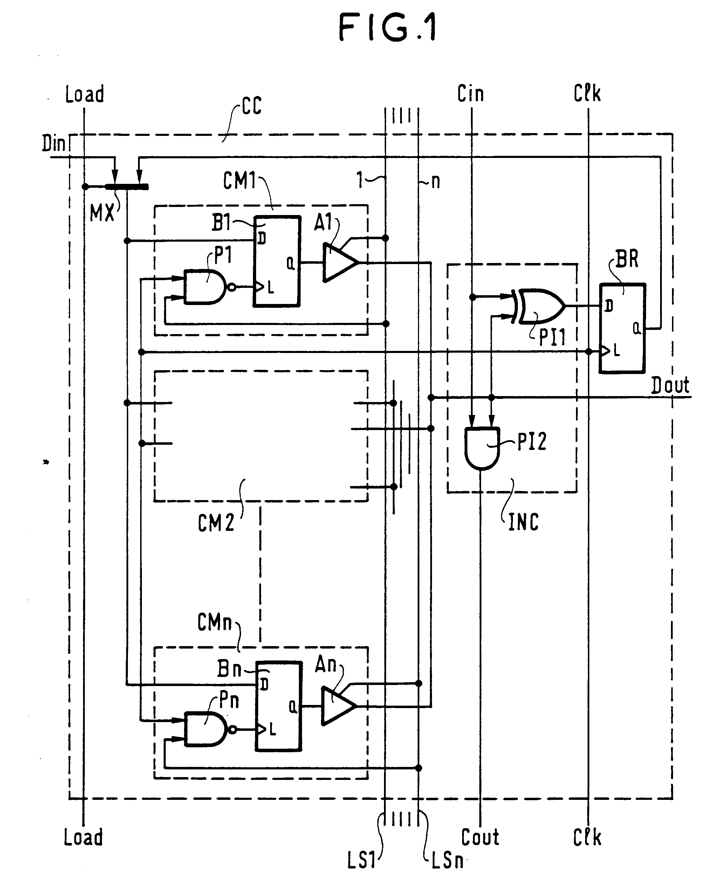

A cet effet, la matrice est construite à partir de m cellules CC1 à CCm comportant chacune n compteurs synchrones pour chacun un bit, une de ces m cellules CC étant montrée figure 1.

Chaque cellule de compteurs CC comporte n cellules de mémoire référencées CM1, CM2, CMn, chaque cellule de mémoire est organisée autour d'un élément mémoire unique par exemple une bascule bistable de mémorisation B, de type D, telle B1 ou Bn.

Chacune des n cellules de mémoire CM d'une même cellule de compteurs CC est susceptible d'être sélectionnée par l'intermédiaire de n liaisons de sélection LS1 à LSn, présentées ici sous forme de liens parallèles selon l'une des deux directions d'orientation rectangulaires du plan de matrice.

Chaque liaison de sélection LS agit sur l'une des cellules de mémoire CM d'une cellule de compteurs CC, étant reliée à cet effet dans la cellule de mémoire CM considérée d'une part à une entrée d'une porte P, de type NAND, telle P1 ou Pn, d'autre part à une entrée de commande d'un amplificateur de sortie A de cette même cellule, tel A1 ou An.

Chaque porte P possède une seconde entrée recevant un signal d'horloge Clk, externe, destiné à assurer la synchronisation de toutes les cellules de mémoire. Le signal de sortie de chaque porte P attaque l'entrée d'horloge de la bascule de mémorisation B de la cellule de mémoire CM qui comporte cette porte.

L'entrée individuelle de données de chacune des bascules de mémorisation B d'une même cellule de compteurs CC est reliée à la sortie unique d'un multiplexeur MX, commun à toutes ces bascules.

Le multiplexeur MX comporte deux entrées de données sélectivement adressables par une liaison de chargement LOAD de manière à alternativement transmettre soit le signal issu d'une liaison d'entrée de données Din individuelle de la cellule de compteurs CC considérée, soit le signal issu d'un élément mémoire ici une bascule de rebouclage BR, de type D, que contient cette cellule de compteurs CC.

La bascule de rebouclage BR d'une cellule de compteurs reçoit le même signal d'horloge Clk que les bascules B de cette cellule de compteurs et elle a son entrée de données reliée en sortie d'un incrémenteur INC.

L'incrémenteur INC d'une cellule de compteurs CC est organisé autour d'une porte d'incrémentation PI1, de type OU exclusif, dont la sortie est reliée à l'entrée de donnée de la bascule de rebouclage BR dans la cellule de compteurs CC qui contient cette porte d'incrémentation PI1. Une entrée de la porte PI1 est reliée à une liaison de sortie Dout à laquelle sont parallèlement connectées les sorties des n amplificateurs A1 à An de cellules de mémoire CM que contient la cellule de compteurs CC considérée.

Une seconde entrée de la porte d'incrémentation PI1, est reliée à une liaison d'entrée de retenue Cin, apte à forcer la sortie de bascule de rebouclage BR au niveau binaire 1 en l'absence de donnée de niveau binaire 1 fournie par celle des bascules de mémorisation B1 à Bn, qui est sélectionnée à un instant donné, de la cellule de compteur CC considérée.

Une porte PI2, de type ET, incorporée dans l'incrémenteur INC, est reliée par une entrée à la liaison d'entrée de retenue Cin qui est accessible de l'extérieur de la cellule de compteurs CC considérée. Une seconde entrée de la porte PI2 est reliée à la liaison Dout en sortie des amplificateurs A1 à An dans la cellule de compteurs CC d'où sort la liaison Dout.

La sortie de la porte PI2 débouche par une liaison de transmission de retenue Cout, hors de la cellule de compteurs CC qui la comporte, de même que la liaison d'entrée de données Din.

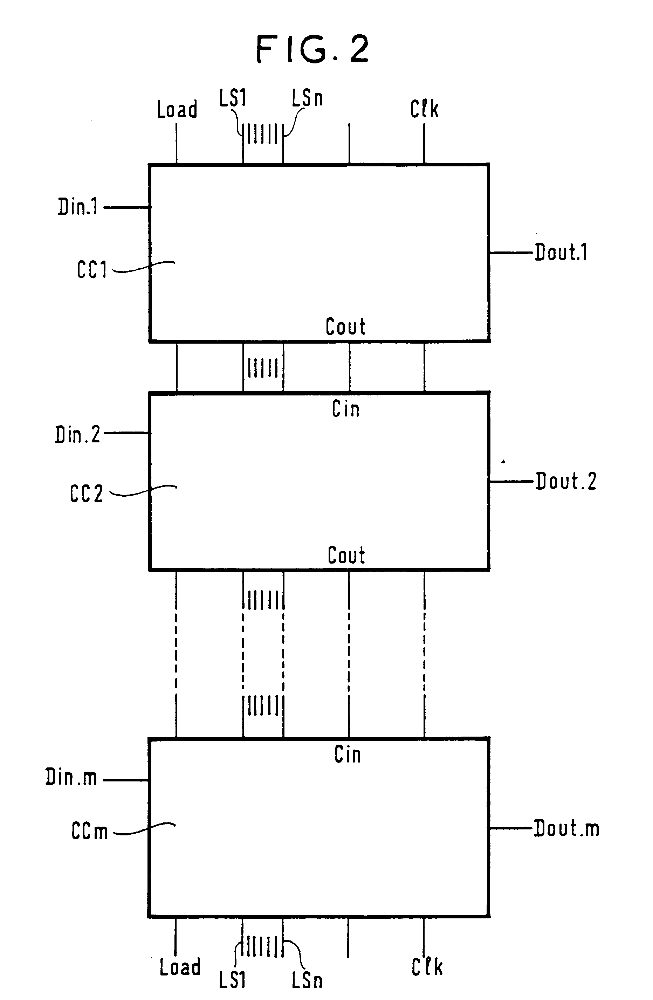

La liaison LOAD, les liaisons de sélection LS1 à LSn et la liaison d'horloge sont communes à la pluralité de cellules de compteurs CC1 à CCn, d'une même matrice de compteurs binaires synchrones multiplexés ainsi qu'on le voit sur la figure 2, elles sont respectivement exploitées par une logique, externe à la matrice et non représentée, chargée d'assurer la commande en liaison avec une horloge également externe et non représentée.

La liaison de chargement LOAD autorise le chargement d'une valeur prédéterminée dans chacune des bascules de mémorisation B d'une matrice à raison d'une bascule de mémorisation par cellule de compteurs CC et par période du signal d'horloge fourni par la liaison Clk d'entrée de données.

A cet effet, la liaison Din, telle Din.1 ou Din.m de chaque cellule de compteurs transmet un signal de valeur binaire un ou zéro, suivant les besoins, au multiplexeur MX auquel elle est individuellement reliée. Ce multiplexeur applique le signal en parallèle aux entrées de données de chacune des bascules de mémorisation BM de la cellule de compteurs qui le comporte.

Ce signal n'est pris en compte que par une seule des bascules de mémorisation de la cellule de compteurs, cette bascule de mémorisation étant celle dont la porte P associée reçoit un signal binaire de sélection qui lui est transmis par la liaison de sélection LS à laquelle ladite porte est reliée.

Les liaisons Cin et Cout d'une cellule de compteurs CC d'une matrice s'étendent respectivement chacune vers une des cellules de compteurs entre lesquelles cette cellule de compteurs est placée dans la suite des cellules de compteurs qui constitue la matrice, sauf bien entendu aux deux extrémités de cette suite.

La liaison Cout permet de transmettre un signal binaire de retenue d'une cellule de mémoire CM sélectionnée par une liaison LS dans une cellule de compteurs CC vers une cellule de mémoire CM également sélectionnée par la même liaison LS dans la cellule de compteurs CC qui suit via la liaison Cin de cette dernière cellule et ainsi de suite.

On obtient donc des cellules de n compteurs à un bit n'impliquant que l'implantation que de n + 1 cellules de mémoires chacune.

La matrice correspondante n'utilise alors que mx (n + 1) éléments de mémoire et elle possède une grande régularité de structure et un nombre réduit de liaisons.

## Revendications

1. Matrice de compteurs binaires, synchrones, multiplexés pour une réalisation en circuit intégré, caractérisée en ce qu'elle est composée d'une suite de m cellules de compteurs (CC1, CCm) dotées chacune d'une liaison individuelle d'entrée de données (Din.1, Din.m) et d'une liaison individuelle de sortie de données (Dout.1, Dout.m) et commandées par l'intermédiaire de liaisons communes comprenant une liaison d'horloge (Clk) pour la synchronisation et n liaisons de sélection (LS1 à LSn), et en ce que chaque cellule de compteurs (CC) comporte n cellules de mémoire (CM1, CMn), qui, organisées chacune autour d'un élément mémoire unique (B1 à Bn) et sélectionnables individuellement par l'intermédiaire des liaisons de sélection (LS1 à LSn), sont connectées en parallèle entre la liaison individuelle d'entrée de données (Din) et la liaison individuelle de sortie de données (Dout) de cette cellule de compteurs (CC) et qui partagent un élément mémoire de rebouclage (BR) commun, connecté par son entrée de données à toutes les liaisons individuelles de sortie de données des cellules de mémoire (CM) de la cellule de compteurs (CC) considérée via une porte OU exclusif commune (PI1) et par sa sortie à l'entrée de données de chacune des n cellules de mémoire (CM1, CMn) parallèles, une porte ET (PI2) commune étant par ailleurs connectée par une entrée à une liaison d'entrée (Cin) en sortie de la porte ET commune de la cellule de compteurs précédente de la suite, par son autre entrée à la liaison individuelle de sortie de données (Dout) et par sa sortie à une liaison de sortie (Cout) en entrée de la porte ET commune de la cellule de compteurs suivante dans la suite, lorsque ces cellules existent, pour permettre la transmission de signaux binaires de retenue d'une cellule de compteurs à la suivante, ladite liaison d'entrée (Cin) en sortie de la cellule de compteurs précédente de la suite étant par ailleurs connectée à la seconde entrée de ladite porte OU exclusif (PI1).

2. Matrice de compteurs, binaires, synchrones, multiplexés' pour circuit intégré selon la revendication 1, caractérisé en ce que chaque cellule de compteurs (CC) comporte un multiplexeur (MX) relié par une entrée à la liaison individuelle d'entrée de données (Din) desservant cette cellule, par une second entrée à la sortie de l'élément mémoire de rebouclage (BR) de la cellule de compteurs, par sa sortie à l'entrée de données d'une bascule bistable (B1, Bn) servant d'élément mémoire dans chacune des cellules de mémoire (CM1, CMn) de cette cellule de compteurs et par son entrée de commande à une liaison de chargement (LOAD) de la matrice.

3. Matrice de compteurs, binaires, synchrones, multiplexés, pour circuit intégré, selon au moins l'une des revendications précédentes caractérisé en ce que l'élément mémoire (B1, Bn) que comporte chaque cellule de mémoire (CM1, CMn) d'une cellule de compteurs (CC1, CCm) est une bascule de type D dont l'entrée d'horloge est commandée par l'intermédiaire d'une porte (P1, Pn) de type NAND dont une entrée est reliée à la liaison d'horloge (Clk), dont une autre entrée est reliée à l'une des liaisons de sélections (LS1, LSn), ladite bascule ayant aussi son entrée de données reliée en sortie du multiplexeur (MX) de la cellule de compteurs qui la comporte et sa sortie reliée à la liaison individuelle de sortie de données (Dout) de cette cellule de compteurs, via un amplificateur de sortie (A1, An) dont l'entrée de commande est reliée à la même liaison de sélection que la porte (P1) de type NAND, contenue dans la même cellule de mémoire que cette bascule.

## Patentansprüche

1. Matrix von multiplexierten, synchronen Binärzählern, die sich für eine Herstellung als integrierte Schaltung eignet, dadurch gekennzeichnet, daß sie aus einer Folge von m Zählerzellen (CC1, CCm) besteht, die je eine individuelle Dateneingangsleitung (Din.1, Din.m) und eine individuelle Datenausgangsleitung (Dout.1, Dout.m) besitzen und über gemeinsame Leitungen gesteuert werden, zu denen eine Taktleitung (Clk) für die Synchronisation und n Auswahlleitungen (LS1 bis LSn) gehören, und daß jede Zählerzelle (CC) n Speicherzellen (CM1, CMn) enthält, die je ein einziges Speicherelement (B1 bis Bn) besitzen und einzeln über Auswahlleitungen (LS1 bis LSn) auswählbar sind sowie parallel zwischen die individuelle Dateneingangsleitung (Din) und die individuelle Datenausgangsleitung (Dout) dieser Zählerzelle angeschlossen sind sowie ein Rückkopplungsspeicherelement (BR) gemeinsam verwenden, das mit seinem Dateneingang an alle individuellen Datenausgangsleitungen der Speicherzellen (CM) der betrachteten Zählerzelle (CC) über ein gemeinsames Exklusiv-ODER-Tor (PI1) und über seinen Ausgang an den Dateneingang jeder der n parallelen Speicherzellen (CM1, CMn) angeschlossen ist, und daß ein gemeinsames UND-Tor (PI2) mit einem Eingang an eine Eingangsleitung (Cin) am Ausgang des gemeinsamen UND-Tors der in der Folge vorausgehenden Zählerzelle, mit seinem zweiten Eingang an die individuelle Datenausgangsleitung (Dout) und mit seinem Ausgang an eine Ausgangsleitung (Cout) am Eingang des gemeinsamen UND-Tors der in der Folge nächsten Zählerzelle angeschlossen ist, sofern diese Zellen existieren, um die Übertragung von binären Übertragssignalen von einer Zählerzelle zur nächsten zu ermöglichen, wobei die Eingangsleitung (Cin) am Ausgang der in der Folge vorhergehenden Zählerzelle außerdem an den zweiten Eingang des Exklusiv-ODER-Tors (PI1) angeschlossen ist.

2. Matrix von multiplexierten, synchronen Binärzählern für eine integrierte Schaltung nach Anspruch 1, dadurch gekennzeichnet, daß jede Zählerzelle (CC) einen Multiplexer (MX) aufweist, der mit einem Eingang an die individuelle diese Zelle bedienende Dateneingangsleitung (Din), mit einem zweiten Eingang an den Ausgang des Rückkopplungsspeicherelements (BR) der Zählerzelle, mit seinem Ausgang an den Dateneingang einer das Speicherelement in jeder der Speicherzellen (CM1, CMn) dieser Zählerzelle bedienende bistabile Kippstufe (B1, Bn) und mit seinem Steuereingang an eine Ladeleitung (LOAD) der Matrix angeschlossen ist.

3. Matrix von multiplexierten, synchronen Binärzählern für eine integrierte Schaltung nach mindestens einem der vorhergehenden Ansprüche, dadurch gekennzeichnet, daß das Speicherelement (B1, Bn) jeder Speicherzelle (CM1, CMn) in einer Zählerzelle (CC1, CCn) eine Kippstufe vom Typ D ist, deren Takteingang über ein UND-NICHT-Tor (P1, Pn) gesteuert wird, welches mit einem Eingang an die Taktleitung (Clk) und mit einem anderen Eingang an eine der Auswahlleitungen (LS1, LSn) angeschlossen ist, und daß die Kippstufe mit ihrem Dateneingang auch an den Ausgang des Multiplexers (MX) der diese Kippstufe enthaltenden Zählerzelle und mit ihrem Ausgang an die individuelle Datenausgangsleitung (Dout) dieser Zählerzelle über einen Ausgangsverstärker (A1, An) angeschlossen ist, dessen Steuereingang an dieselbe Auswahlleitung wie das UND-NICHT-Tor (P1) angeschlossen ist, welches in derselben Speicherzelle wie diese Kippstufe liegt.

## Claims

1. A matrix of multiplexed synchronous binary counters for an integrated circuit embodiment, the matrix being characterized in that it comprises a sequence of m counter cells (CC1, CCm) each provided with an individual data input link (Din.1, Din.m) and with an individual data output link (Dout.1, Dout.m) and controlled by means of common links including a clock link (Clk) for synchronization, and n select links (LS1 to LSn), and in that each counter cell (CC) includes n memory cells (CM1, CMn) which, each organized about a single memory element (B1 to Bn) and individually selectable by means of the select links (LS1 to LSn), are connected in parallel between the individual data input link (Din) and the individual data output link (Dout) of the counter cell (CC) which share a common loop memory element (BR) having its data input connected to all the individual data output links of the memory cells (CM) of the counter cell (CC) under consideration via a common exclusive-OR gate (PI1) and its output connected to the data input of each of the n parallel memory cells (CM1, CMn), a common AND gate (PI2) being also connected via an input to an input link (Cin) output from the common AND gate of the preceding counter cell in the sequence, via its other individual input link of data output (Dout) and via its output to an output link (Cout) constituting an input to the common AND gate of the following counter cell in the sequence, when such cells exist, thereby enabling binary carry signals to be transmitted from one counter cell to the next, said input link (Cin) at the output of the preceding counter cell in the sequence being also connected to the second input of said exclusive-OR gate (PI1).

2. A matrix of multiplexed synchronous binary counters for an integrated circuit according to claim 1, characterized in that each counter cell (CC) includes a multiplexer (MX) connected via one input to the individual data input link (Din) serving said cell, via a second input to the output from the loop memory element (BR) of the counter cell, via its output to the data input of a bistable flip-flop (B1, Bn) serving the memory element in each of the memory cells (CM1, Cmn) of said counter cell, and via its control input to the load link (LOAD) of the matrix.

3. A matrix of multiplexed synchronous binary counters for an integrated circuit according to at least one of the preceding claims, characterized in that the memory element (B1, Bn) included in each memory cell (B1, Bn) of a counter cell (CC1, CCn) is a D type bistable whose clock input is controlled by means of a respective NAND type gate (P1, Pn) having one input connected to the clock link (Clk), having another input connected to one of the select links (LS1, LSn), said bistable also having its data input connected to the output of the multiplexer (Mx) of the counter cell in which it is included, and its output connected to the individual data output link (Dout) of said counter cell via an output amplifier (A1, An) whose control input is connected to the same select link as the NAND type gate (P1) contained in the same memory cell as said bistable.
